# EUROPEAN PATENT APPLICATION

(11) **EP 1 591 799 A1**
(43) Date of publication of application: **02.11.2005**
(21) Application number: 04101811.0
(22) Date of filing: 29.04.2004
(51) Int. Cl.: G01R 33/561

(54) **Magnetic resonance steady state imaging**

(71) Applicant: Koninklijke Philips Electronics N.V., 5621 BA Eindhoven (NL)
(72) Inventor: The designation of the inventor has not yet been filed
(74) Representative: Cohen, Julius Simon

(57) **Abstract**

A high-sensitivity acquisition involves a (dynamic) steady-state that is achieved by repetitive applying flip angles with the same sign. Read-out of the magnetic resonance signals is done in the form of gradient echoes that are generated by applying temporary magnetic gradient fields. Preferably, all gradients are completely compensated for. Accordingly, a so-called Rephased Fast-Field Echo (R-FFE) sequence is employed as the high-sensitivity acquisition sequence. It appears that a high-sensitivity is achieved when a flip angle in the range from 3° to 15° is employed. High-sensitivity is achieved for very low concentrations of contrast agent in the range of about 1-10nmol.

## Description

The invention pertains to a magnetic resonance imaging system that is arranged to perform steady-state magnetic resonance imaging.

Steady-state magnetic resonance imaging is known from the handbook *'Magnetic resonance imaging'* (2^{nd} edition) by M.T. Vlaardingerbroek and J.A. den Boer (Springer Berlin 1999).

In general, steady-state magnetic resonance imaging methods have a very short total scan time to acquire the magnetic resonance signals. Successive RF-excitations are performed in the formed of a series of successive RF-excitation pulses, such that the longitudinal magnetisation and possibly also the transverse magnetisation do not relax back to zero. The magnetisation before an RF-excitation pulse is then caused by many earlier RF-excitation pulses. After a number of RF-excitation pulses a dynamic equilibrium builds up where both longitudinal and transverse magnetisation components are present.
In contrast enhanced magnetic resonance imaging methods a contrast agent that influences the contrast in the magnetic resonance signals is administered to the patient to be examined. For example, a Gd-based contrast agent that causes shortening of the *T*₁-relaxation time of blood can be employed. Often, in contrast enhanced magnetic resonance imaging, spoiled FFE acquisition sequences, such as Balanced FFE (B-FFE) are employed. In spoiled FFE then different contributions of the transverse magnetisation interact destructively, which leads to magnetic resonance images that are primarily T₁-weighted. This approach has proven to be successful when relatively high concentrations of the contrast agent are employed. Further, in spoiled FFE magnetic resonance imaging methods the contrast increases as the repetition rate *T*_{R} is shorter.

An object of the invention is to provide an magnetic resonance imaging system that is able to detect very low concentrations of the contrast agent.

This object is achieved by a magnetic resonance imaging system of the invention comprising
- an RF-excitation system
- a gradient encoding system
- an RF-receiver system and
- a control system to control the RF-excitation system, the gradient encoding system and the RF-receiver system and
- the control system being arranged to
   - perform a high-sensitivity acquisition sequence to acquire high-sensitivity magnetic resonance signals,
   - the high-sensitivity acquisition sequence including successive RF-excitation pulses involving predetermined flip angles having the same sign.

According to the invention, the high-sensitivity acquisition involves a steady-state that is achieved by repetitive applying flip angles with the same sign. Read-out of the magnetic resonance signals is done in the form of gradient echoes that are generated by applying temporary magnetic gradient fields. Preferably, all gradients are completely compensated for. Accordingly, a so-called Rephased Fast-Field Echo (R-FFE) sequence is employed as the high-sensitivity acquisition sequence. It appears that a high-sensitivity is achieved when a flip angle in the range from 3° to 15° is employed. High-sensitivity is achieved for very low concentrations of contrast agent in the range of about 1-10nmol. Hence, the invention enables magnetic resonance imaging with very low concentrations of targeted contrast agent. That is, the magnetic resonance imaging system of the invention enables molecular imaging. Particularly good results are found for a flip angle of 3.5°.

These and other aspects of the invention will be further elaborated with reference to the embodiments defined in the dependent Claims.

Although in the R-FFE sequence preferably all gradients are compensated for, some residual uncompensated gradient fields may remain i.e. due to inhomogeneities of the magnetic field, i.e. inhomogeneities of the main stationary magnetic field and also due to imperfections of the temporary magnetic gradient fields. These imperfections may lead to band-like artefacts in the magnetic resonance image. These band-like artefacts can be reduced further by employing phase increments to the successive RF-excitations in each repetition time *T*_{R}. Also employing short repetition time, e.g. *T*_{R}<3ms avoids the build-up of phase-differences that add to the band-artefacts. According to a further aspect of the invention an imaging acquisition sequence is performed to acquire imaging magnetic resonance signals. A magnetic resonance image is reconstructed from these imaging magnetic resonance signals. Any acquisition sequence that is relatively insensitive to inhomogeneities of the magnetic field can be used as the imaging acquisition sequence. Suitable imaging acquisition sequences are e.g. a Balanced FFE sequence. On the basis of the magnetic resonance image that is reconstructed from the imaging magnetic resonance signals the shim system of the magnetic resonance imaging system is adjusted to further remove field inhomogeneities, notably in a small region of interest. Then the high-sensitivity acquisition sequence is carried-out at the shimming set on the basis of the magnetic resonance image. This aspect of the invention is based on the insight that often the size of a *region of interest,* notably a tumour, is less than the size of banding artefacts due to residual field inhomogeneities and that the effective *field-of-view* that is hardly or not at all affected by the banding artefacts is substantially larger than the size of the *region of interest.* Accordingly, accurate shimming leads to localisation of the banding artefacts that does not or hardly affect the imaging of the *region of interest* on the basis of the high-sensitivity magnetic resonance signals. The shim gradients that effect the accurate shimming are adjusted for the *region of interest.* To this end, a 3D *region of interest,* e.g. in the form of a box within the patient to be examined is selected. Next, saturation of spins beyond the selected box is performed, e.g. by way of a PRESS sequence. Subsequently, echoes from the box are measured at respective read gradient fields, notably three successive orthogonal read gradients are employed. The local inhomogeneity of the main magnetic field is then derived from the instants at which for these three read gradients the echo top from the selected box occurs. Finally, a stationary offset is applied to the gradient fields to compensate the inhomogeneities of the main magnetic field within the selected box. Preferably, the echo tops are measured using an acquisition sequence that is predominantly (proton) density weighted and which has only a weak T₁ and T₂ weighting.

According to a further aspect of the invention an overview magnetic resonance image is reconstructed from the imaging magnetic resonance signals and a high-sensitivity magnetic resonance image is reconstructed from the high-sensitivity magnetic resonance signals. This overview magnetic resonance image and the high-sensitivity magnetic resonance image may be displayed together, successively or next to one another. For example, a combined magnetic resonance image may be formed of pixels reconstructed from the overview magnetic resonance image and the high-sensitivity magnetic resonance image, respectively. The overview magnetic resonance image carries information on the anatomy surrounding a *region of interest,* e.g. a tumour and the high-sensitivity magnetic resonance image carries information that pertains to the *region of interest,* such as a tumour, itself. The combined magnetic resonance image provides additional information to the user, e.g. to the radiologist, in that the tumour is shown in the anatomic surroundings.

The invention further relates to a magnetic resonance imaging method as defined in Claim 5. The magnetic resonance imaging method of the invention enables magnetic resonance imaging with very low concentrations of targeted contrast agent. The invention also relates to a computer programme as defined in Claim 6. The computer programme of the invention enables a magnetic resonance imaging system to enable magnetic resonance imaging with very low concentrations of targeted contrast agent. The computer programme of the invention can be installed in the processing system of the magnetic resonance imaging system. The computer programme of the invention can be supplied on a data carrier such as a CD-ROM and may also be down loaded e.g. in the form of digital signals, from a data network, such as the world-wide web.

These and other aspects of the invention will be elucidated with reference to the embodiments described hereinafter and with reference to the accompanying drawing wherein
Figure 1 shows diagrammatically a magnetic resonance imaging system in which the invention is used.
Figure 2 shows the calculated signal enhancement for the three sequences as function of the *T*₂/*T*₁ ratio.
In Figure 3 the SNR of the reference sample, without Gd-DTPA, for the three sequences is plotted.
Figure 4 shows the measured CNR as a function of the Gd-DTPA concentration.

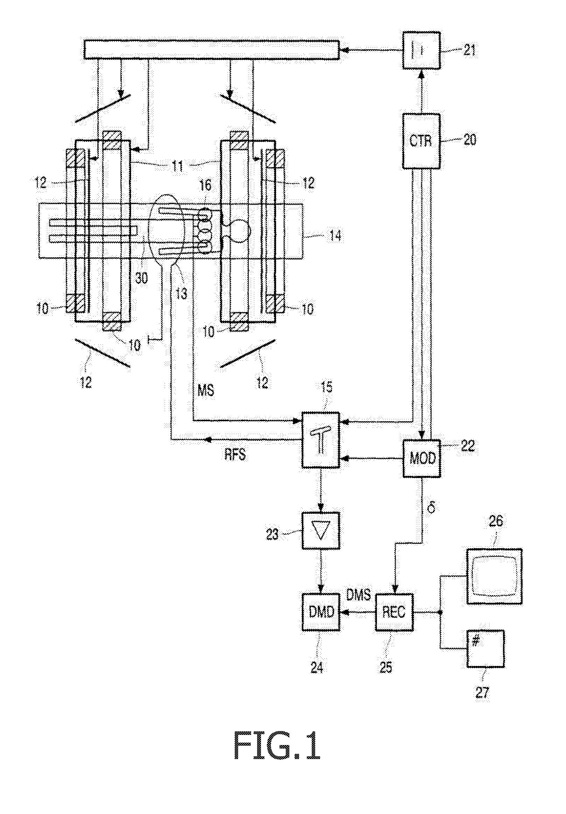

Figure 1 shows diagrammatically a magnetic resonance imaging system in which the invention is used. The magnetic resonance imaging system includes a set of main coils 10 whereby the steady, uniform magnetic field is generated. The main coils are constructed, for example in such a manner that they enclose a tunnel-shaped examination space. The patient to be examined is placed on a patient carrier which is slid into this tunnel-shaped examination space. The magnetic resonance imaging system also includes a number of gradient coils 11, 12 whereby magnetic fields exhibiting spatial variations, notably in the form of temporary gradients in individual directions, are generated so as to be superposed on the uniform magnetic field. The gradient coils 11, 12 are connected to a controllable power supply unit 21. the gradient coils 11, 12 are energised by application of an electric current by means of the power supply unit 21. The strength, direction and duration of the gradients are controlled by control of the power supply unit. The magnetic resonance imaging system also includes transmission and receiving coils 13, 16 for generating the RF excitation pulses and for picking up the magnetic resonance signals, respectively. The transmission coil 13 is preferably constructed as a body coil 13 whereby (a part of) the object to be examined can be enclosed. The body coil is usually arranged in the magnetic resonance imaging system in such a manner that the patient 30 to be examined is enclosed by the body coil 13 when he or she is arranged in the magnetic resonance imaging system. The body coil 13 acts as a transmission antenna for the transmission of the RF excitation pulses and RF refocusing pulses. Preferably, the body coil 13 involves a spatially uniform intensity distribution of the transmitted RF pulses (RFS). The same coil or antenna is usually used alternately as the transmission coil and the receiving coil. Furthermore, the transmission and receiving coil is usually shaped as a coil, but other geometries where the transmission and receiving coil acts as a transmission and receiving antenna for RF electromagnetic signals are also feasible. The transmission and receiving coil 13 is connected to an electronic transmission and receiving circuit 15.

It is to be noted that it is alternatively possible to use separate receiving and/or transmission coils 16. For example, surface coils 16 can be used as receiving and/or transmission coils. Such surface coils have a high sensitivity in a comparatively small volume. The receiving coils, such as the surface coils, are connected to a demodulator 24 and the received magnetic resonance signals (MS) are demodulated by means of the demodulator 24. The demodulated magnetic resonance signals (DMS) are applied to a reconstruction unit. The receiving coil is connected to a preamplifier 23. The preamplifier 23 amplifies the RF resonance signal (MS) received by the receiving coil 16 and the amplified RF resonance signal is applied to a demodulator 24. The demodulator 24 demodulates the amplified RF resonance signal. The demodulated resonance signal contains the actual information concerning the local spin densities in the part of the object to be imaged. Furthermore, the transmission and receiving circuit 15 is connected to a modulator 22. The modulator 22 and the transmission and receiving circuit 15 activate the transmission coil 13 so as to transmit the RF excitation and refocusing pulses. The reconstruction unit derives one or more image signals from the demodulated magnetic resonance signals (DMS), which image signals represent the image information of the imaged part of the object to be examined. The reconstruction unit 25 in practice is constructed preferably as a digital image processing unit 25 which is programmed so as to derive from the demodulated magnetic resonance signals the image signals which represent the image information of the part of the object to be imaged. The signal on the output of the reconstruction monitor 26, so that the monitor can display the magnetic resonance image. It is alternatively possible to store the signal from the reconstruction unit 25 in a buffer unit 27 while awaiting further processing.

The magnetic resonance imaging system according to the invention is also provided with a control unit 20, for example in the form of a computer which includes a (micro)processor. The control unit 20 controls the execution of the RF excitations and the application of the temporary gradient fields. The control unit also controls the shim settings of the magnetic resonance imaging system in order to reduce inhomogeneities in the stationary magnetic field. To this end, the computer program according to the invention is loaded, for example, into the control unit 20 and the reconstruction unit 25.

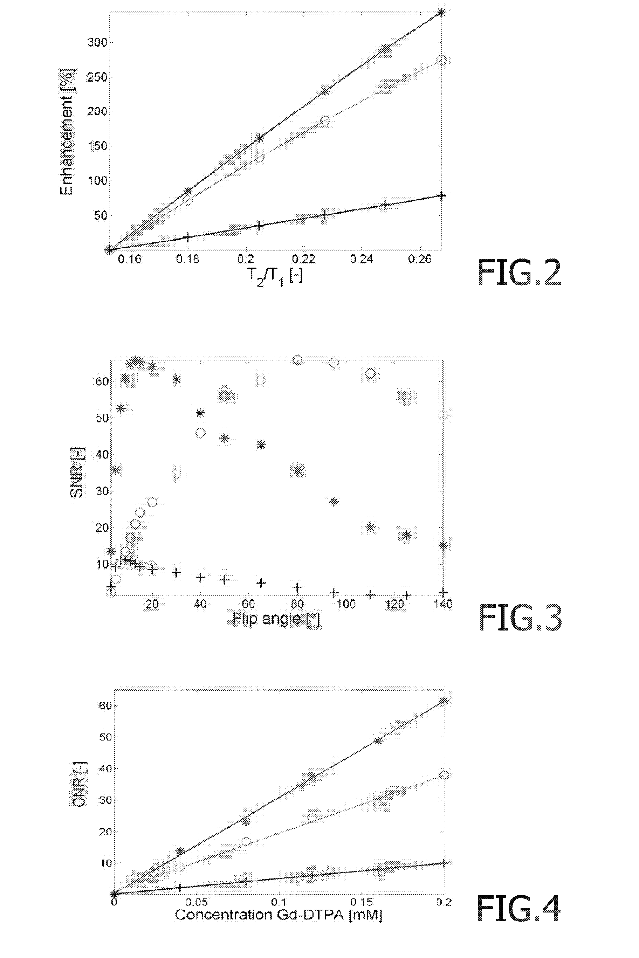

With reference to Figures 2, 3 and 4 we show that Balanced-FFE and Rephased-FFE (steady state fully coherent gradient echo sequences, echo as well as FID rephased) offer a marked gain in sensitivity of up to a factor 6 in the detection of low concentrations of contrast agent, when compared to the commonly used *T*₁-FFE sequence. The increased sensitivity is demonstrated both theoretically and experimentally using a concentration series of Gd-DTPA in MnCl₂ doped water.

In Figure 2, the calculated signal enhancement (reference signal is the reference sample with *T*1-FFE) of *T*1-FFE (+), Balanced-FFE (O) and Rephased-FFE (*) at theoretical optimum flip angles, with the T2/T1 ratios of the six samples. These six samples (MnCl₂ solution (13 mg/l), Ø=22 mm) with increasing Gd-DTPA concentrations, 0/0.04/0.08/0.12/0.16/0.2 mM, were bundled in a head-coil and imaged with a 1.5 T MRI scanner (Philips Medical Systems, Best). The images were made with the following parameters: TR/TE = 4/1.69-2 ms, matrix=128², NSA=8 and FOV=14x14 cm². Prior to the measurements, the *B*₀ field was shimmed locally and the scan-preparation parameters were fixed. The Balanced-FFE, Rephased-FFE, and *T*₁-FFE images were recorded as a function of the flip angle. Calculations (²) were performed using the experimentally determined *T*₂/*T*₁ ratio of the samples. The reference sample (no Gd-DTPA) had a *T*_{*2*}/*T*_{*1*} ratio of 215/1406 ms/ms. The relaxivities *R*₁ and *R*₂ of the solutions were 4.1 and 5.5 s⁻¹mM⁻¹, respectively.

The images of the samples were analysed by calculating the mean values of the signal to noise ratio (SNR) in a region of interest. For the flip angle, at which the 0.2 mM sample showed the highest enhancement, the SNRs of each sample were subtracted from the SNR of the reference sample. In this way we obtained the contrast to noise ratio (CNR) as a function of concentration. The sensitivity was defined as the change in CNR per mM Gd - DTPA concentration.

Figure 3 shows SNR of the reference sample (no Gd-DTPA) as function of the flip angle. Symbols are as in figure 2.

Figure 3 shows the calculated signal enhancement for the three sequences as function of the *T*₂/*T*₁ ratio. The theoretical optimum flip angles were 9°, 77° and 1° for *T*_{*1*}-FFE, Balanced-FFE and Rephased-FFE, respectively. The graph clearly demonstrates, that for both Balanced-FFE and Rephased-FFE a striking gain in signal enhancement is predicted. In Figure 3 the SNR of the reference sample, without Gd-DTPA, for the three sequences is plotted. The shapes are in accordance with the theory.

Figure 4 shows CNR increase relative to [GD-DTPA]=0 as a function of the Gd-DTPA concentration of the six samples.

Symbols as in figure 2. Figure 4 shows the measured CNR as a function of the Gd-DTPA concentration. Note that the successive points in figure 4 correspond to the *T*₂/*T*₁ ratio points in figure 1. The flip angles for the maximum CNR of the three sequences were 15°, 125° and 65° for *T*_{*1*}-FFE, Balanced-FFE and Rephased-FFE, respectively. The sensitivity of these sequences (Fig. 4) is almost constant in the observed range of concentrations. The sensitivities for the Gd-DTPA solutions are 49 mM⁻¹ (r²=0.9984) for *T*_{*1*}-FFE, 184 mM⁻¹ (r²=0.9919) for Balanced-FFE and 305 mM⁻¹ (r²= 0.9982) for Rephased-FFE. As compared to *T*_{*1*}-FFE, Rephased-FFE and Balanced-FFE show a dramatic increase in sensitivity, in agreement with figure 3.

The signal enhancements predicted by the calculations were in good agreement with the measured signal enhancements, considering the fact that our simple model calculations did not take into account the slice profile and residual *B*₀ inhomogeneities. All sequences showed excellent linearity of the sensitivity as function of concentration, which is critical for quantification purposes. The Rephased-FFE displays the highest sensitivity, which makes this sequence the most attractive for molecular imaging with MRI. Another advantage of Rephased-FFE is the lower flip angle needed, which allows for very short repetition times, even at high field strengths for which SAR limits become important.

In conclusion, we have shown that steady state fully coherent gradient echo sequences, such as Balanced-FFE and Rephased-FFE, offer a marked gain in sensitivity in the detection of low concentrations of Gd-DTPA as compared to *T*_{*1*}-FFE. These sequences are therefore attractive candidates for the *in vivo* detection of disease markers using targeted contrast agents.

## Claims

1. A magnetic resonance imaging system comprising
- an RF-excitation system
- a gradient encoding system
- an RF-receiver system and
- a control system to control the RF-excitation system, the gradient encoding system and the RF-receiver system and
- the control system being arranged to
- perform a high-sensitivity acquisition sequence to acquire high-sensitivity magnetic resonance signals,
- the high-sensitivity acquisition sequence including successive RF-excitation pulses involving predetermined flip angles having the same sign.

2. A magnetic resonance imaging system as claimed in Claim 1, wherein the flip angles are in the range between 3° and 15°.

3. A magnetic resonance imaging system as claimed in Claim 1, including
- a main magnet to produce a stationary magnetic field
- a shim system to shim the stationary magnetic field
- a reconstruction system to reconstruct a magnetic resonance image
- the control system being arranged to perform an imaging acquisition sequence to acquire imaging magnetic resonance signals
- the control system being arranged to control the shim system and the reconstruction system to
- reconstruct a magnetic resonance image of a *region of interest* from the imaging magnetic resonance signals and to
- control the shimming of the stationary magnetic field on the basis of the magnetic resonance image of the *region of interest.*

4. A magnetic resonance imaging system as claimed in Claim 3, wherein
- the reconstruction system is arranged to
- reconstruct a high-sensitivity magnetic resonance image from the high-sensitivity magnetic resonance signals and
- to reconstruct an overview magnetic resonance image from the imaging magnetic resonance signals.

5. A magnetic resonance imaging method including
- performing an imaging acquisition sequence to acquire imaging magnetic resonance signals
- reconstruct an magnetic resonance image of a *region of interest* from the imaging magnetic resonance signals
- set shimming for said *region of interest* on the basis of the acquired imaging magnetic resonance signals
- performing a high-sensitivity acquisition sequence to acquire high-sensitivity magnetic resonance signals at the set shimming
- the high-sensitivity acquisition sequence including successive RF-excitation pulses involving predetermined flip angles having the same sign.

6. A computer programme including instructions for
- performing an imaging acquisition sequence to acquire imaging magnetic resonance signals
- reconstruct an magnetic resonance image of a *region of interest* from the imaging magnetic resonance signals
- set shimming for said *region of interest* on the basis of the acquired imaging magnetic resonance signals
- performing a high-sensitivity acquisition sequence to acquire high-sensitivity magnetic resonance signals at the set shimming
- the high-sensitivity acquisition sequence including successive RF-excitation pulses involving predetermined flip angles having the same sign.
